**Europäisches Patentamt**

**European Patent Office**

**Office européen des brevets**

(19)

(11) Veröffentlichungsnummer: **0 458 300 A2**

## EUROPÄISCHE PATENTANMELDUNG

(12)

(21) Anmeldenummer: **91108270.9**

(22) Anmeldetag: **22.05.91**

(51) Int. Cl.5: **B60R 16/02**

(30) Priorität: **23.05.90 HU 314790**

(43) Veröffentlichungstag der Anmeldung:
**27.11.91 Patentblatt 91/48**

(84) Benannte Vertragsstaaten:
**AT DE FR GB**

(71) Anmelder: **Csepel Autogyár**
**Pf. 38**
**H-2311 Szigetszentmiklos(HU)**

(72) Erfinder: **Simonyi, Sándor, Dr.Dipl.-Ing.**
**Baglyasalja, Petöfi u.59**
**H-3102 Salg tarján(HU)**
Erfinder: **Szab , Ferenc**
**Kállai Eva u. 3**
**H-3100 Salg tarján(HU)**
Erfinder: **Vál czi, György, Dipl.-Ing.**
**Budapesti t. 40**
**H-3104 Salg tarján(HU)**

(74) Vertreter: **Patentanwälte Viering & Jentschura**
**Steinsdorfstrasse 6 Postfach 22 14 43**
**W-8000 München 22(DE)**

(54) **Funktionsprüfung rechnergesteuerter elektrischer Betätigungskomponenten in einem Kraftfahrzeug.**

(57) Funktionsprüfung rechnergesteuerter elektrischer Betätigungskomponenten (1) in einem Kraftfahrzeug, die in eine elektrische Schaltung mit einem Speisespannungszweig und einem Erdungszweig eingeschaltet ist, wobei, rechnergesteuert, eine in den Speisespannungszweig oder den Erdungszweig der Betätigungskomponente (1) eingeschaltete elektrische Schalterstufe (4) mit Strombegrenzung abwechselnd ein- und ausgeschaltet wird und, rechnergesteuert, eine künstliche Belastung (2) abwechselnd an die Betätigungskomponente (1) in parallelschaltung angeschaltet und von der Betätigungskomponente (1) abgetrennt wird, wobei der jeweilige Spannungsabfall über die Schalterstufe (4) hin in den durch das Ein- und Ausschalten der Schalterstufe und das Anschalten und Abtrennen der künstlichen Belastung (2) bestimmten Schaltzuständen, die einander überlagert werden, mit im Rechner (8) gespeicherten Sollwerten verglichen wird.

Fig.1

Die Erfindung betrifft ein Verfahren und eine Einrichtung zur Funktionsprüfung einer rechnergesteuerten elektrischen Betätigungskomponente in einem Kraftfahrzeug, die in eine elektrische Schaltung mit einem Speisespannungszweig und einem Erdungszweig eingeschaltet ist.

Insbesondere betrifft die Erfindung die Kontrolle von mittels eines Rechners gesteuerten Ausgangsperipherien in einem Kraftfahrzeug und den elektrischen Betätigungskomponenten dieser Ausgangsperipherien, wobei die Erfindung vorzugsweise zur Überwachung einer Steuerung eines automatischen Stufenschaltgetriebes des Kraftfahrzeugs vorgesehen ist, um die Aufrechterhaltung des Betriebs des Kraftfahrzeug beim Vorliegen elektrischer Fehler in den im allgemeinen als Elektromagnete elektromagnetischer Ventile zum Schalten des Getriebes ausgebildeten Betätigungskomponenten und in deren Steuerschaltung sicherzustellen.

Bei bekannten Systemen wurden die elektrischen Betätigungskomponenten entweder überhaupt nicht auf ihre einwandfreie Funktion überprüft, oder es konnte nur das Vorhandensein von Fehlern festgestellt werden, nicht aber die Art des Fehlers aufgedeckt werden.

Durch die Erfindung wird das technische Problem gelöst, ein Verfahren und eine Einrichtung zur Funktionsprüfung einer rechnergesteuerten elektrischen Betätigungskomponente in einem Kraftfahrzeug bereitzustellen, die während des Betriebs des Kraftfahrzeugs nicht nur das Aufdecken des Vorliegens elektrischer Fehler in der elektrischen Betätigungskomponente ermöglichen, sondern auch die Feststellung der Art des elektrischen Fehlers, wie das Vorliegen eines Kurzschlusses oder einer Unterbrechung in einem elektrischen Leiter oder in einem elektrischen Bauteil gestatten. Als Erfolg der Erfindung kann in Kenntnis der Art des Fehlers beispielsweise in eine automatische Getriebesteuerung so eingegriffen werden, daß die von dem Fehler beeinträchtigte Gangstufe durch entsprechende Änderung der Steuerungsparameter übergangen wird.

Zur Lösung des Problems ist das Verfahren gemäß der Erfindung zur Funktionsprüfung einer rechnergesteuerten elektrischen Betätigungskomponente in einem Kraftfahrzeug, die in eine elektrische Schaltung mit einem Speisespannungszweig und einem Erdungszweig eingeschaltet ist, ist insbesondere dadurch gekennzeichnet, daß, rechnergesteuert, eine in den Speisespannungszweig oder den Erdungszweig der Betätigungskomponente eingeschaltete elektrische Schalterstufe mit Strombegrenzung abwechselnd ein- und ausgeschaltet wird und, rechnergesteuert, eine künstliche Belastung abwechselnd an die Betätigungskomponente in Parallelschaltung angeschaltet und von der Betätigungskomponente abgetrennt wird, wobei der jeweilige Spannungsabfall über die Schalterstufe hin in den durch das Ein- und Ausschalten der Schalterstufe und das Anschalten und Abtrennen der künstlichen Belastung bestimmten Schaltzuständen, die einander überlagert werden, mit gespeicherten Sollwerten verglichen wird.

Die erfindungsgemäße Einrichtung zur Funktionsprüfung einer von einem Rechner gesteuerten elektrischen Betätigungskomponente in einem Kraftfahrzeug, die in eine elektrische Schaltung mit einem Speisespannungszweig und einem Erdungszweig eingeschaltet ist, ist insbesondere dadurch gekennzeichnet, daß die elektrische Schaltung eine in den Speisespannungszweig oder in den Erdungszweig der elektrischen Betätigungskomponente eingeschaltete, von dem Rechner gesteuerte elektrische Schalterstufe mit Strombegrenzung, einen eine künstliche Belastung angebenden Belastungswiderstand und einen von dem Rechner gesteuerten Schalter aufweist, mit welchem der Belastungswiderstand in Parallelschaltung zu der Betätigungskomponente an diese anschaltbar oder von dieser abtrennbar ist, und daß parallel zu der Schalterstufe ein Spannungsteiler geschaltet ist, dessen Teilungsspannungsausgang über eine Rückführleitung in den Rechner zur Spannungsmessung und zum Vergleichen der Meßwerte mit gespeicherten Sollwerten zurückgeführt ist.

Vorzugsweise ist die erfindungsgemäße Einrichtung zur Funktionsprüfung mehrerer elektrischer Betätigungskomponenten in einem Kraftfahrzeug geeignet. Hierzu sind die einzelnen Betätigungskomponenten in jeweils eine solche erfindungsgemäße elektrische Schaltung eingeschaltet, die vorstehend beschrieben ist, wobei die Teilungsspannungsausgänge der Spannungsteiler der Schaltungen über einen von dem Rechner gesteuerten Multiplexer an die den Schaltungen gemeinsame Rückführleitung angeschlossen sind.

Durch das Abfragen der Spannungszustände in den vier möglichen Kombinationen der Schaltzustände der Schalterstufe und des Schalters zum Anschalten bzw. Abtrennen der künstlichen Belastung und durch den Vergleich mit entsprechend angepaßten Spannungssollwerten können vorliegende elektrische Fehler auch der Art nach erkannt werden. Ziel der Erfindung ist es, den Fehler zu kompensieren; jedoch kann der Fehler, da dieser von dem Regelungsspeicher kontinuierlich gespeichert werden muß, auch aus dem Speicher ausgelesen werden.

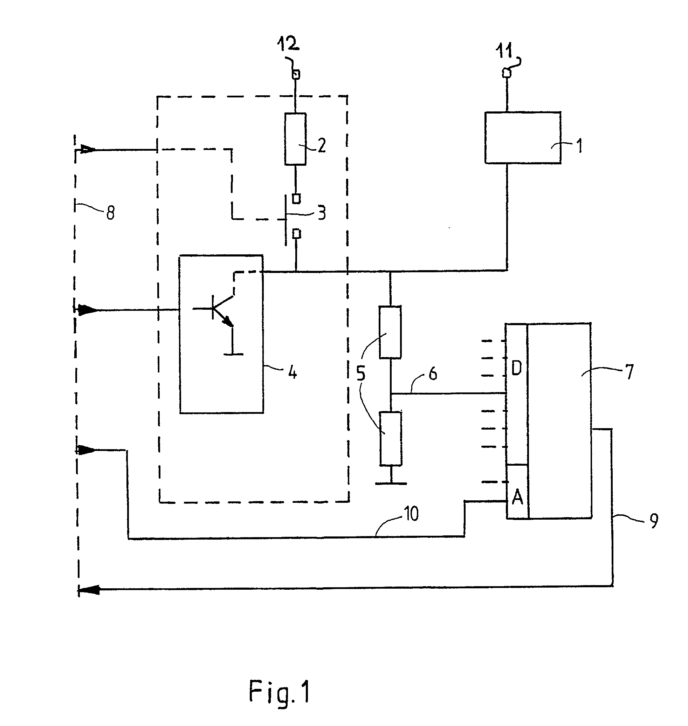

Die Erfindung wird mithilfe einer Ausführungsform einer elektrischen Schaltung erläutert, die aus der einzigen Figur der Zeichnung ersichtlich ist.

Der Hardware-Anspruch der erfindungsgemäßen Lösung besteht in einer an die Ausgangsschnittstelle des Rechners angeschlossene hochstromige, mit Strombegrenzung versehene Schalterstufe ausschaltenden Charakters, deren Ausgang direkt oder mit der Untersuchungsadreßbus multiplexiert an die Schnittstellenleitung zurückgelesen werden kann, und einem an der hochstromigen Schalterstufe angeschlossenen, zu der elektrischen Betätigungskomponente parallel an diese anschließbare künstliche Belastung, die ebenfalls aus einer Schnittstellenleitung des Rechners heraus schaltbar ist.

Demgemäß ist entsprechend der Zeichnung die elektrische Betätigungskomponente 1 in eine elektrische Schaltung eingeschaltet, in welche die von dem Rechner 8 gesteuerte elektrische Schalterstufe 4, und zwar im Ausführungsbeispiel in den Erdungszweig eingeschaltet ist. Die Schalterstufe 4 weist beispielsweise einen Transistor und andere erforderliche Elemente wie einen Stromnbegrenzungswiderstand auf und schaltet im geschlossenen Zustand eine als Belastungswiderstand 2 ausgebildete künstliche Belastung, der über einen von dem Rechner 8 gesteuerten Schalter 3 parallel zu der Betätigungskomponente 1 an diese anschaltbar ist, bzw. die Betätigungskomponente 1 an das Erdpotential. Zwischen der schalterstufe 4 und der Betätigungskomponente ist ein Spannungsteiler 5 abgezweigt, dessen Teilungsspannungsausgang 6 über einen Multiplexer 7 an eine zu dem Rechner 8 zurückgeführte Rückführleitung 9 angeschlossen ist.

In der Zeichnung ist nur eine Überwachungsschaltung für nur eine zu überwachende Betätigungskomponente dargestellt. Tatsächlich werden jedoch mehrere Betätigungskomponenten mit entsprechenden Überwachungsschaltungen überwacht, die mit den Teilungsspannungsausgängen ihrer Spannungsteiler über den Multiplexer 7, gesteuert von dem Adressbus 10, zyklisch nacheinander an die Rückführleitung 9 geschaltet werden. Wenn in der Praxis jedoch nur eine elektrische Betätigungskommponente 1 überwacht wird, entfällt der Multiplexer 7, so daß die Rückführleitung 9 dann unmittelbar an den Teilungsspannungsanschluß 6 des Spannungsteilers 5 angeschlossen ist. Auch besteht die Möglichkeit, mehrere Betätigungskomponenten parallel zueinander zu überwachen, wobei für jede der Überwachungsschaltungen eine gesonderte Rückführleitung 9 zum Rechner 8 zurückgeführt ist.

Nach der Zeichnung ist die Schalterstufe 4 in den Erdungszweig der Schaltung eingeschaltet. Stattdessen kann sie aber auch in den Speisespannungszweig zwischen dem Speisespannungsanschluß 11 der Schaltung und der Betätigungskomponente 1 eingeschaltet sein, wobei der Spannungsteiler dann ebenfalls parallel zur Schalterstufe geschaltet ist und das Potential an den Speisespannungsanschlüssen 11 und 12 der Betätigungskomponente 1 bzw. des Belastungswiderstandes 2 das gleiche ist.

Die erfindungsgemäße Fehleruntersuchung beruht auf dem Schalten und Zurücklesen von an der Betätigungskomponente 1 ausgegebenen kurzen Impulsen. Aus den möglichen vier Kombinationen der Schaltzustände der Schalterstufe 4 bzw. des Belastungswiderstandes 2 können durch Vergleich der abgegriffenen Spannung mit den im Rechner gespeicherten Sollwerten vier unterschiedliche Schlußfolgerungen gezogen werden:

1. - Das System ist in Ordnung

2. - Es liegt ein Kurzschluß an dem zur Betätigungskomponente 1 führenden Ausgang der Schalterstufe 4 vor

3. - Stromunterbrechung an der Betätigungskomponente 1

4. - Stromunterbrechung am Ausgang der Schalterstufe 4 oder Kurzschluß an der Betätigungskomponente 1.

Für die folgende Erläuterung ist mit "Ausgang" der zur Betätigungskomponente 1 führende Ausgang der Schalterstufe 4, und mit "Eingang" deren von dem Rechner 8 angesteuerter Eingang gemeint, wohingegen unter ein- bzw. ausgeschalteter "Diagnostik" das Anschalten bzw. Abtrennen des Belastungswiderstandes 2 zu verstehen ist.

Die Entscheidung wird entsprechend der gespeicherten Spannungssollwerte wie folgt getroffen:

a.) Falls die Diagnostik ausgeschaltet ist und auch der Eingang ausgeschaltet ist und das Signal an dem Ausgang diesen Schaltzuständen entspricht, und danach der Eingang eingeschaltet wird und dem das Signal am Ausgang entspricht, dann ist das System in Ordnung.

b.) Falls die Diagnostik ausgeschaltet ist und der Eingang auch ausgeschaltet ist, jedoch das Signal am Ausgang diesen Schaltzuständen nicht entspricht, d.h. das Ausgangssignal nicht richtig ist, und falls danach die Diagnostik eingeschaltet ist und der Eingang ebenfalls eingeschaltet ist und diesen Schaltzuständen das Signal am Ausgang entspricht, dann ist der Ausgang der Schalterstufe ist kurzgeschlossen; falls aber das Signal am Ausgang jetzt ebenfalls nicht richtig, dann ist ein Kurzschluß an der Betätigungskomponente 1 vorhanden.

c.) Falls hingegen die Diagnostik ausgeschaltet ist und der Eingang ebenfalls ausgeschaltet ist und dabei das Signal am Ausgang richtig ist, und falls danach der Eingang eingeschaltet ist und der Ausgang nicht richtig ist, dann ist entweder am Ausgang eine Stromunterbrechung vorhanden oder die Betätigungskomponente 1 ist kurzgeschlossen.

Es ist, wie oben bereits angegeben, für den Fachmann ersichtilich, daß die "Richtigkeit" bzw. "Unrichtigkeit" des Signals am Ausgang in Funktion der gegebenen Schaltzustände in dem Rechnerspeicher gespeichert sind, der Mikrocomputer daher in Wirklichkeit untersucht, ob er einen dem gespeicherten Wert entsprechenden oder einen davon abweichenden Wert zurückgelesen bekommt.

Einerseits geben diese Informationen dem Servicefachmann eine erhebliche Hilfe in der schnellen Fehlerbeseitigung, andererseits aber kann die Zentraleinheit den weiteren Fahrbetrieb mit einer Reduzierung auf "teilweiser" Funktion erlauben, wobei - falls möglich - die sich auf die fehlerhaften Betätigungskomponenten beziehenden Betriebszustände übergangen werden, und wobei in Betracht gezogen wird, ob der Fehler einen fortsetzbaren Betrieb oder Unsteuerbarkeit bedeutet.

Die erfindungsgemäße Lösung wurde bei einem von einem Rechner gesteuerten, völlig automatischen mechanischen Getriebe angewendet, wobei die Schalterstufen 4 sich in hybrid integrierten Schaltungen befanden, in die auch die diagnostizierenden Belastungswiderstände 2 und die diese schaltenden Transistor-Schalter 3 eingebaut waren, wie dies in der Zeichnung aus dem gestrichelt umrahmten Schaltungsteil ersichtlich ist.

Als Betätigungsvorrichtung waren elektropneumatische Ventile vorgesehen, die die verschiedenen Gangstufen schalten und deren Elektromagnete als Betätigungskomponeten 1 zwischen eine Speisespannung von 24 Volt und Erdungspotential unter Verwendung erfindungsgemäßer Überwachungsschaltungen eingeschaltet angeschlossen waren. Im Falle des Auftretens eines Fehlers ist hier z.B. die Möglichkeit zum Übergehen der fehlerhaften Gangstufen gegeben, falls die zu den jeweiligen schaltpunkten gehörenden Parametern der Steuerung entsprechend geändert werden.

**Patentansprüche**

1. Verfahren zur Funktionsprüfung einer rechnergesteuerten elektrischen Betätigungskomponente in einem Kraftfahrzeug, die in eine elektrische Schaltung mit einem Speisespannungszweig und einem Erdungszweig eingeschaltet ist, dadurch gekennzeichnet, daß, rechnergesteuert, eine in den Speisespannungszweig oder den Erdungszweig der Betätigungskomponente eingeschaltete elektrische Schalterstufe mit Strombegrenzung abwechselnd ein- und ausgeschaltet wird und, rechnergesteuert, eine künstliche Belastung abwechselnd an die Betätigungskomponente in Parallelschaltung angeschaltet und von der Betätigungskomponente abgetrennt wird, wobei der jeweilige Spannungsabfall über die Schalterstufe hin in den durch das Ein- und Ausschalten der Schalterstufe und das Anschalten und Abtrennen der künstlichen Belastung bestimmten Schaltzuständen, die einander überlagert werden, mit gespeicherten Sollwerten verglichen wird.

2. Einrichtung zur Funktionsprüfung einer von einem Rechner (8) gesteuerten elektrischen Betätigungskomponente (1) in einem Kraftfahrzeug, die in eine elektrische Schaltung mit einem Speisespannungszweig und einem Erdungszweig eingeschaltet ist, dadurch gekennzeichnet, daß die elektrische Schaltung eine in den Speisespannungszweig oder in den Erdungszweig der elektrischen Betätigungskomponente (1) eingeschaltete, von dem Rechner (8) gesteuerte elektrische Schalterstufe (4) mit Strombegrenzung, einen eine künstliche Belastung angebenden Belastungswiderstand (2) und einen von dem Rechner (8) gesteuerten Schalter (3) aufweist, mit welchem der Belastungswiderstand (2) in Parallelschaltung zu der Betätigungskomponente (1) an diese anschaltbar oder von dieser abtrennbar ist, und daß parallel zu der Schalterstufe (4) ein Spannungsteiler (5) geschaltet ist, dessen Teilungsspannungsausgang (6) über eine Rückführleitung (9) in den Rechner (8) zur Spannungsmessung und zum Vergleichen der Meßwerte mit gespeicherten Sollwerten zurückgeführt ist.

3. Einrichtung zur Funktionsprüfung mehrerer elektrischer Betätigungskomponenten (1) in einem Kraftfahrzeug, dadurch gekennzeichnet, daß die Betätigungskomponenten (1) in jeweils eine elektrische Schaltung gemäß Anspruch 2 eingeschaltet sind, wobei die Teilungsspannungsausgänge (6) über einen von dem Rechner (8) gesteuerten Multiplexer (7) an die den Schaltungen gemeinsame Rückführleitung (9) angeschlossen sind.

Fig.1